# EUROPEAN PATENT APPLICATION

(11) **EP 4 513 569 A1**
(43) Date of publication of application: **26.02.2025**
(21) Application number: 23193218.7
(22) Date of filing: 24.08.2023
(51) Int. Cl.: H01L 29/40, H01L 29/66, H01L 29/78

(54) **METHOD OF MANUFACTURING MOSFETS**

(71) Applicant: Nexperia B.V., 6534 AB Nijmegen (NL)
(72) Inventor: Pandey, Deepak Chandra, Manchester (GB); Peake, Steven, Manchester (GB)
(74) Representative: Pjanovic, Ilija

(57) **Abstract**

A method of manufacturing a semiconductor power device, the method comprising forming at least two trench regions within a semiconductor region, etching each trench region such that the mesa region extends above an upper surface of each trench region, and forming a plurality of spacers, where the spacers are located over each trench region and are adjacent to the mesa region.

## Description

### Technical Field

The present disclosure relates to a power semiconductor device and a method of manufacturing a power semiconductor device, particularly but not exclusively, the present disclosure relates to a split-gate metal-oxide semiconductor field-effect transistor (MOSFET).

### Background

Trench metal-oxide-semiconductor field-effect transistors (MOSFETs) are widely known and used in many applications. In a trench MOSFET, current is conducted vertically from one surface of the MOSFET to the other surface of the MOSFET.

It is desired to produce MOSFET devices having a reduced cell pitch, for example having a cell pitch of less than 1.0 µm or less than 800nm, which increases reliance on lithography definition and alignment tolerance to avoid source-gate short-circuiting. Generally, the smallest device pitch available is around 1µm, where the mesa region has a width of approximately 500nm and the contact width is approximately 200nm. In order to decrease cell pitch, other device dimensions may need to be reduced. Lithography, as well as contact-to-trench alignment, are limiting factors in achieving this reduced cell pitch and device dimensions.

Any misalignment of the source contact of a MOSFET, and thus deviation in the contact-to-trench distance, forces the implanted heavy-dose of p-type dopants (in some example, Boron) into the conduction channel on one side of the cell while depriving the other side of the cell of the p-type dopant. This leads to an imbalance of threshold voltage (V_{T}) between the two sides of the cell, which in turn has knock-on effects on both On-Resistance (R_{ON}) and ruggedness of the device.

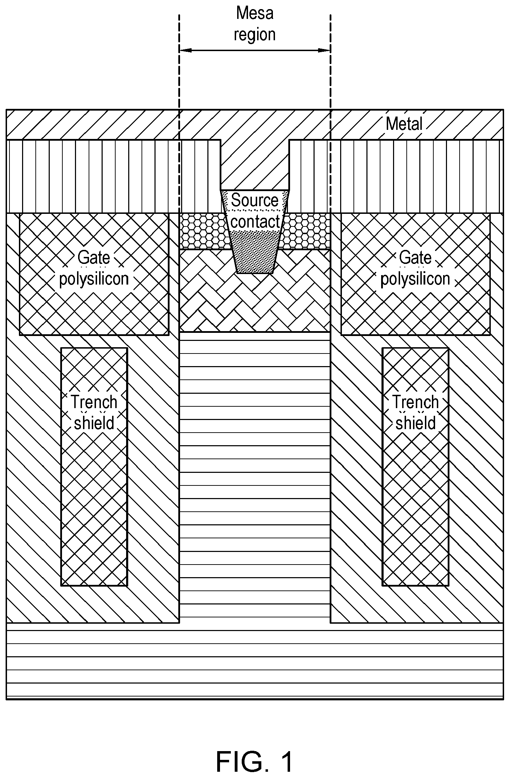

As an example, Figure 1 shows schematically a cross-section of a state-of-the-art split-gate MOSFET. As the cell pitch shrinks, it becomes challenging to print smaller feature size using the available tools. The source contact and gate pickup contacts of the device have to be accurately positioned to avoid a short between the gate and source. Throughout the application, a source contact may also refer to a source contact region, n+ source contact region or n-type doped region.

US 7,579,649 B2 relates to a device that has source regions arranged above insulated gates in trenches, and US 2020/0243679 A1 relates to a device in which the source metallisation is arranged above the gate trench of the semiconductor device

### Summary

Aspects and preferred features are set out in the accompany claims.

According to a first aspect of the disclosure, there is provided a method of manufacturing a semiconductor power device, the method comprising:
forming at least two trench regions within a semiconductor region, wherein two laterally adjacent trench regions are separate by a mesa region of the semiconductor region;
etching each trench region such that the mesa region extends above an upper surface of each trench region;
forming a plurality of spacers, wherein the spacers are located over each trench region and are adjacent to the mesa region;
forming an insulating region over an upper surface of the device; and etching the insulating region.

The steps of the herein disclosed method may be performed in the order as listed above. In particular, the step of etching the insulating region may be performed after the step of forming the plurality of spacers. This allows the etching process to be limited by the spacers, i.e. a width or depth of an etched region is determined by the spacers. Alternatively, a step of forming a contact region of a conductivity type may be limited by the spacers such that the position of the contact region is determined by the spacers.

The insulating region and the spacers may have a high etch selectivity. In other words, the materials used for the insulating region and the spacers may etch at significantly different etch rates when exposed to a given etchant. This allows the insulating region to be etched, and the etch process to stop either on the surface of the spacers or at a small depth within the spacers.

Etching the insulating region may comprise performing an etch process that terminates on or within the plurality of spacers. This increases tolerance of the etch process and allows greater control of the etched region, without using an additional lithography step. This allows formation of a device having reduced cell pitch.

Etching the insulating region may comprise etching the insulating material over the trench regions to form an etched gate recess. Etching the insulating region may comprise etching the insulation material over the trench regions and etching a semiconductor or conductive region within the trench region. A width of the etched gate recess may be limited by the spacers. This laterally aligns the etched gate recess, such that it prevents a subsequently formed gate contact from contacting the mesa region and subsequently short-circuiting the device.

The method may further comprise forming a gate contact by depositing a conductive material in the etched gate recess. The conductive material may be an n-type doped polysilicon, and more specifically an n+ polysilicon.

Etching the insulating region may comprise etching the insulating material above the mesa region to form an etched source recess. A depth of the etched source recess may be limited by the spacers. This prevents the etched source recess from extending down to the trench regions, such that it prevents a subsequently formed source contact from contacting the trench region (in particular a gate conductive region of the trenches) and subsequently short-circuiting the device.

The method may further comprise forming a source contact by depositing a conductive material in the etched source recess.

Etching the insulating region may comprise performing an etch process that terminates on an upper surface of the mesa region.

The method may further comprise forming a source contact by depositing a conductive material over the upper surface of the mesa region. The source contact may be located completely above the semiconductor region.

In some examples, the insulating region and the spacers may not have a high etch selectivity. The etch process that terminates on an upper surface of the mesa region may stop at an upper surface of the mesa region. This allows a subsequently formed source contact to be formed completely over the semiconductor region. As the mesa region extends above an upper surface of each trench region, this prevents the subsequently formed source contact from contacting the trench region (in particular a gate conductive region of the trenches) and subsequently short-circuiting the device.

After etching each trench region, the method may further comprise forming a conductive region in each trench region. The conductive region may be formed such that the mesa region extends above an upper surface of the conductive region. Etching the trench region may comprise etching a trench recess having a depth such that a subsequently formed conductive region does not extend to the upper surface of the mesa region.

The conductive region may comprise a gate conductive region. Forming each trench region may comprise forming a split-gate trench region having a gate conductive region within an upper region of each split-gate trench region. Etching each trench region may comprise etching the gate conductive region such that the mesa region extends above an upper surface of the gate conductive region.

Forming each trench region may comprise forming a conductive region in an etched trench recess. Etching each trench region may comprise etching the conductive region such that the mesa region extends above an upper surface of the conductive region.

The conductive region may comprise a gate conductive region. Forming each trench region may comprise forming a split-gate trench region having a gate conductive region within an upper region of each split-gate trench region. Etching each trench region may comprise etching the gate conductive region such that the mesa region extends above an upper surface of the gate conductive region.

In other words, etching each trench region such that the mesa region extends above an upper surface of each trench region may comprise:
(i) etching a trench recess, and after etching the trench recess, forming a conductive region within the trench recess, wherein the trench recess is etched to a depth such that the mesa region extends above an upper surface of the formed conductive region; and/or
(ii) etching a trench recess, and after etching the trench recess, forming a conductive region within the trench recess, and after forming a conductive region, etching the conductive region such that the mesa region extends above an upper surface of the formed conductive region.

Prior to forming the spacers, the method may further comprise forming a plurality of contact regions of a first conductivity type within the mesa region. Forming the plurality of contact regions may comprise depositing a dopant of a first conductivity type over an upper surface of the device, and thermally diffusing the dopant of a first conductivity type into the mesa region. This allows greater control of the formation of the plurality of contact regions, such that the formed contact regions of a first conductivity type may each comprise an upper portion and a lower portion. The lower portion may be in contact with a sidewall of one of the trench regions. The upper portion may be located in the mesa region above the upper surface of the trench regions. This allows the source contact to contact a top surface of the contact regions, whilst allowing the contact regions to be located along the sidewall of the trenches.

After forming the spacers, the method further may further comprise forming a plurality of contact regions of a second conductivity type within the mesa region. The second conductivity type may be an opposite conductivity type to the first conductivity type. The spacers may act as a mask during implantation of the contact regions of a second conductivity type. This allows greater control of the formation of the contact regions of a second conductivity type.

According to a further aspect of the disclosure, there is provided a method of manufacturing a semiconductor device having an active region and a gate pickup region, comprising forming a semiconductor device including a source contact in the active region as described above, and forming a semiconductor device including a gate contact in the gate pickup region as described above. The steps of forming the source contact and forming the gate contact may be performed simultaneously. Simultaneously forming the source contact and the gate contact reduces the time and steps required to form a semiconductor device having an active region and a gate pickup region.

According to a further aspect of the disclosure, there is provided a semiconductor power device formed using the method as described above.

According to a further aspect of the disclosure, there is provided a semiconductor power device, comprising:
a semiconductor region;
at least two trench regions within the semiconductor region, wherein each trench region comprises a conductive region, and wherein two laterally adjacent trench regions are separated by a mesa region of the semiconductor region, and wherein the mesa region extends above an upper surface of each trench region;
two or more contact regions of a first conductivity type located in the mesa region and wherein the contact regions are in contact with the two adjacent trench regions so that, in use, a channel is formed along a side of each trench region; and
a plurality of spacers located over each trench region and adjacent to the mesa region.

The mesa region extending above an upper surface of the trench regions, allows the spacers to define subsequently formed source and/or gate contacts, or doped conductivity regions such that manufacturing tolerances of the device can be improved and cell pitch reduced.

The semiconductor power device may further comprise an insulating region located over the trench regions and/or the mesa region.

The spacers and the insulating region may have a high etch selectivity. In other words, the materials used for the insulating region and the spacers may etch at significantly different etch rates when exposed to a given etchant. This allows the insulating region to be etched, and the etch process to stop either on the surface of the spacers or at a small depth within the spacers.

The insulating region may be formed of a different material to the spacers. The insulating region may comprise an oxide and the spacers may comprise a nitride.

Each trench region may comprise a conductive region. The device may further comprise a gate contact coupled with a conductive region of at least one trench region. The gate contact may be located laterally between two spacers. The spacers may laterally align the etched gate recess, such that the subsequently formed gate contact is prevented from contacting the mesa region and subsequently short-circuiting the device.

The insulating region may be formed of the same material as the spacers. The insulating region and the spacers may both comprise an oxide.

The contact regions of a first conductivity type may each comprise an upper portion and a lower portion. The lower portion may be in contact with a sidewall of one of the trench regions. The upper portion may be located in the mesa region above the upper surface of the trench regions. This allows the source contact to contact a top surface of the contact regions, whilst allowing the contact regions to be located along the sidewall of the trenches.

The device may comprise a source contact located completely over the mesa region. As the mesa region extends above an upper surface of each trench region, this prevents the subsequently formed source contact from contacting the trench region (in particular a gate conductive region of the trenches) and subsequently short-circuiting the device.

The trench regions may comprise split-gate trench regions, each comprising:
an upper conductive region formed in an upper portion of each split-gate trench region;
a lower conductive region formed in a lower portion of each split-gate trench region; and
an insulation layer formed along sidewalls, a lower surface of each split-gate trench regions and between the upper conductive region and the lower conductive region. The mesa region may extend above an upper surface of the upper conductive region of each trench region.

The semiconductor device may comprise a metal-oxide-semiconductor field-effect transistor (MOSFET).

According to a further aspect of the disclosure, there is provided a semiconductor power device having an active region and a gate pickup region, where the active region comprises a semiconductor device having a source contact as described above, and the gate pickup region comprises a semiconductor device having a gate contact as described above.

The method of manufacture and corresponding device of the present disclosure has the following advantages over state-of-the-art devices:
- the self-aligned manufacturing process enables pitch shrinking without requiring any additional mask;
- the spacer provides protection against source-gate shorting;
- the ratio of n+ contact area and p+ contact area improves avalanche ruggedness;
- the method can be used to form the active area and gate pickup region of a device simultaneously;
- the method of manufacture enables a device having sub-micron cell pitch; and
- the device can be a low to high voltage MOSFET (25V to 150V).

### Brief Description of the Figures

Some embodiments of the disclosure will now be described, by way of example only and with reference to the accompanying drawings, in which:
Figure 1 shows schematically a cross-section of a state-of-the-art split-gate MOSFET;
Figure 2 shows schematically steps in a method of manufacturing a MOSFET according to an embodiment of the disclosure;
Figure 3 shows schematically steps of forming spacers in the method of Figure 2;
Figure 4 shows a further step in the method of manufacturing a MOSFET as shown in Figure 2.
Figure 5 shows an alternative further step in the method of manufacturing a MOSFET as shown in Figure 2;
Figure 6 shows a simulation of steps in a method of manufacturing a MOSFET according to an embodiment of the disclosure;
Figure 7 shows a simulated cross-section of a split-gate MOSFET according to an embodiment of the disclosure;
Figure 8 shows a simulation of BVdss of a MOSFET according to an embodiment of the disclosure; and
Figure 9 shows a simulation of specific on-state resistance of a MOSFET according to an embodiment of the disclosure.

### Detailed Description of the Preferred Embodiments

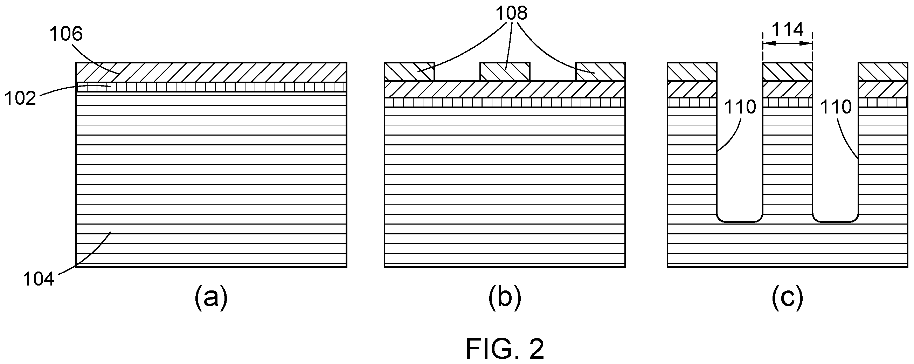

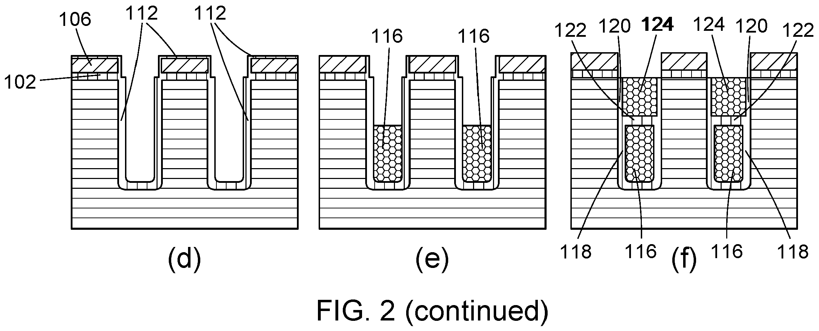

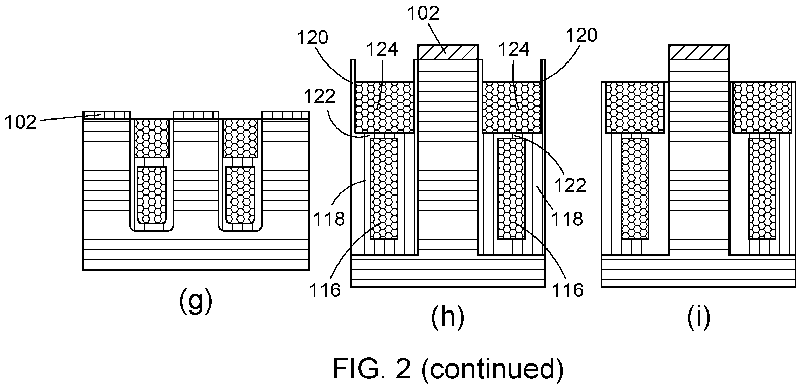

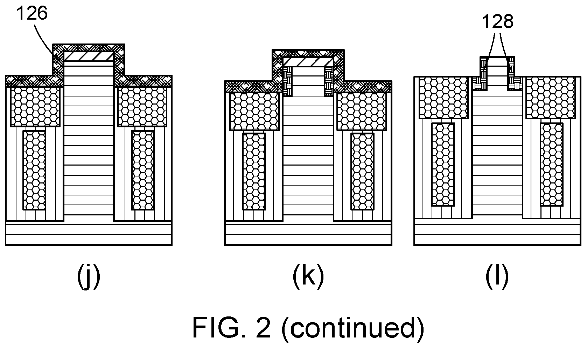

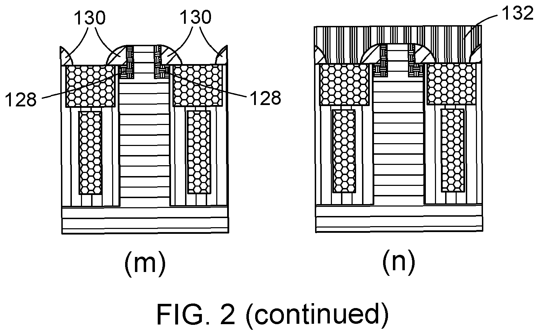

Figures 2(a) to 2(n) show schematically steps in a method of manufacturing a split-gate MOSFET. Whilst Figures 2(a) to 2(n) show steps in manufacturing an area of a MOSFET having two gate trenches 110, it will be understood that the method may be used to manufacture more than two gate trenches. It will be appreciated that the steps shown in Figure 2 may illustrate a subset of all the steps for manufacturing a device, and that the method may further include additional steps preceding or following the steps of Figure 2.

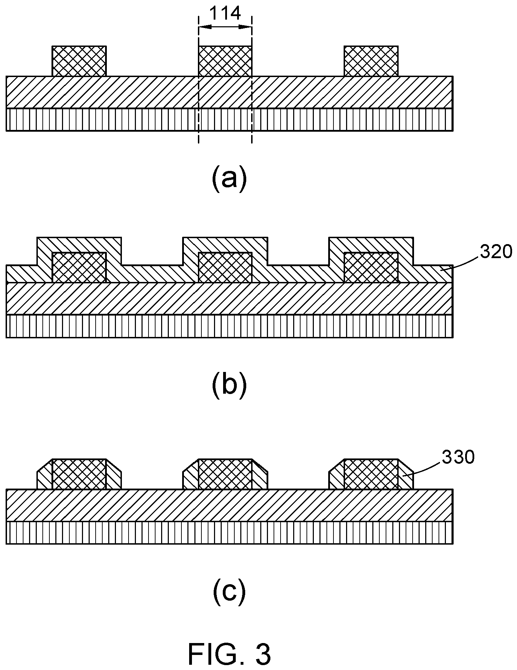

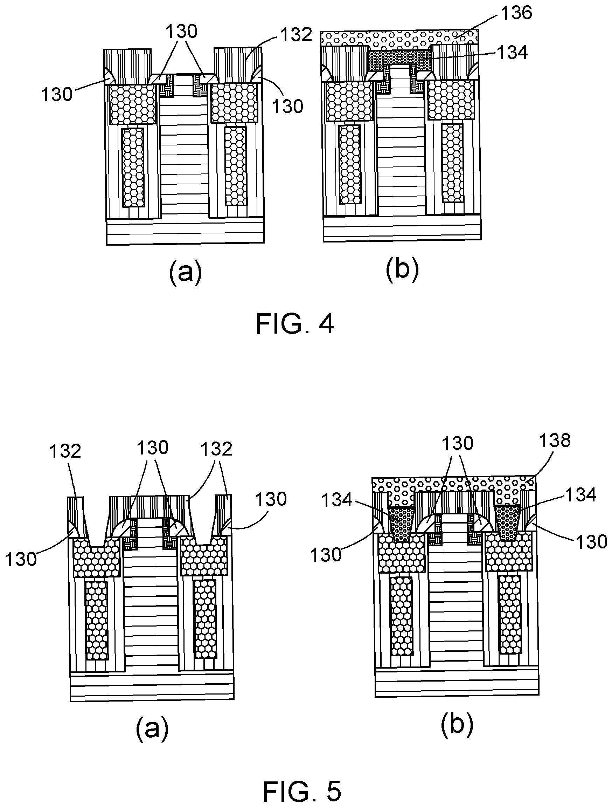

The steps of the method shown in Figure 2 are performed in order from (a) to (n) as follows:
(a) A pad oxide layer 102 is grown over a semiconductor substrate 104. In the example described, the substrate is a silicon substrate though other semiconductor materials may be used as an alternative. A nitride layer 106 is deposited over the pad oxide layer 102. A further oxide layer (not shown) may be deposited over the pad oxide layer 102, before depositing the nitride layer. The nitride layer may be Si₃N₄ and acts as a hard mask or resist layer to protect the mesa region (not shown) between the trenches during the manufacturing process of the device. In some examples, the p-body region and the p+ contact region may be implanted at this stage, by implanting with Boron in a low energy (30keV to 180keV) process;
(b) A photoresist layer 108 is deposited over the nitride layer 106. The photoresist layer is patterned to define the trenches during the etch process and as such may only be present over the mesa region (not shown) between trenches;
(c) Two trenches 110 are etched in the semiconductor region 104. The pad oxide layer 102 and the nitride layer 108 are also etched above the trenches. The mesa region 114 is located between adjacent trenches. The photoresist layer 108 can be stripped either before the semiconductor region 104 is etched (between etching the pad oxide layer 102 and the nitride layer 108 and etching the semiconductor region 104) or after etching the semiconductor region 104. The trenches 110 may be etched to be deeper than trenches in state-of-the-art devices (for example, the initial over etch of the trenches may be between 100nm and 300nm, more specifically the trenches may be etched to be approximately 0.15um deeper than known devices), such that the mesa region 114 of the device extends above an upper surface of the trenches of the device. The total trench depth will depend upon the V_{ds} (drain-source) rating of the device, the total trench depth may be between 2.5µm (at a lowest V_{ds} rating) to 10µm (at a highest V_{ds} rating);
(d) A liner oxide layer 112 is thermally grown or deposited on the inner walls and lower surface of each trench 110 and over the upper surface of the mesa region 114 between adjacent trenches 110;
(e) Polysilicon (or poly) is deposited within the two trenches and over an upper surface of the device. The polysilicon is planarised using chemical mechanical planarization (CMP). An etching process is performed to etch the polysilicon within the trenches 110, such that the source polysilicon is recessed below the upper surface of the trenches 110 and forms a buried field plate 116;
(f) A further etching process is performed to etch back the liner oxide layer 112 in the mesa region 114 and along the sidewalls of the trenches 110 above the buried field plate 116, such that a thick oxide liner 118 remains only along the sidewalls adjacent to the buried field plate 116.
   The further etching process may be performed so that only a thin oxide liner 120 (also referred to as the gate oxide layer) remains along the mesa region 114 and the sidewalls of the trenches 110 at a shallower depth than the buried field plate 116, where the thin oxide liner 120 has a thickness substantially less than the thick oxide liner 118.
   Alternatively, the liner oxide layer 112 may be completely removed along the mesa region 114 and the sidewalls of the trenches 110 at a shallower depth than the buried field plate 116. A thin oxide layer 120 is then formed along the sidewalls of the trenches 110 at a shallower depth than the buried field plate 116, where the thin oxide liner 120 has a thickness substantially less than the thick oxide liner 118. The thin oxide layer 120 may be grown after the inter-poly oxide 122 is formed. The thin oxide layer 120 may be thermally grown at a high temperature (approximately 1100°C) oxidation to ensure a high quality oxide. The thin oxide layer 120 may have a thickness range between 30nm to 80nm depending upon the threshold voltage of the device.
   Further oxide 122 (also referred to as the inter-poly oxide) is then formed within the trenches 110 (this may be done using high-density-plasma chemical vapour deposition or by oxidation), over the buried field plate 116 within the trenches 110. The formation of the inter-poly oxide 122 may involve depositing and then etching the oxide.
   Alternatively, both the gate oxide layer 120 and the inter-poly oxide 122 may be formed in a single oxidation process.
   A conductive polysilicon region is then deposited over the device and within each trench 110. The conductive polysilicon region is then planarised using chemical mechanical planarization (CMP) or using a dry-etch step. This forms the gate polysilicon region 124. The inter-poly oxide 122 separate the gate polysilicon region 124 from the source polysilicon region 116;
(g) The nitride layer 106 is then stripped or removed from the mesa region 114 on the upper surface of the device;
(h) The gate polysilicon region 124 is recessed below the upper surface of the silicon in the mesa region 114. This may be performed using an etching process. The mesa region 114 is protected by the oxide layer 102 which acts as a hard mask;
(i) An etch process is performed to remove the thin oxide layer 120 along both sidewalls of each trench, above the upper surface of the gate polysilicon region 126;
(j) An n-type doped polysilicon 126 is deposited over the upper surface of device including over the trenches 110 and the mesa region 114 such that a layer 128 of the n-type doped polysilicon is formed over the exposed upper surfaces of the trenches 110, mesa region 114 and the exposed regions of the sidewalls of the trenches. This may be done using chemical vapour deposition (CVD) or using atomic layer deposition (ALD);
(k) The device is annealed at a high temperature to thermally drive or diffuse the dopants from the n-type doped polysilicon layer 126 into the mesa region 114 to form an n-type doped region 128 (also referred to as an n+ source contact region) within the silicon substrate 104 in the mesa region 114 and adjacent to the trenches 110. The n-doped region 128 may be formed of Arsenic. The n-type doped region 128 has an L-shape that is formed by dopants diffusing both horizontally and vertically into the mesa region 114.
   This process is done using diffusion rather than implantation, which can create damage to the silicon and leave interstitial sites after annealing. The use of diffusion thereby reduces the risk of defects in the diffusion. Doping by diffusion allows the doping profile to be more precisely controlled by controlling the thermal profile.
   In some examples, the n-type doped region 128 has a thickness greater than or equal to 1nm. The extent (depth and lateral spread) of the N+ source region is determined by the thermal process (temperature and time). Typically, the depth will be approximately 0.2µm and the lateral spread will be 0.1µm to 0.3µm depending upon the width of the mesa region. The length or height of the n-type doped region 128 may extend deeper or shallower within the p-body region than shown in the Figures, although it is advantageous for the n-type doped region 128 to not extend within the channel formed alongside the sidewalls of the trenches 110;
(l) A silicon isotropic etch is performed on the device. The isotropic etch etches in all directions simultaneously. The etch process may be an over-etch to ensure that the etchant removes some silicon entirely (across a wafer) the layer we want to etch. This etch process removes an excess polysilicon threads or stringers that are formed on vertical edges of the device. If left on the device, these can cause the device to short circuit. A further etch step to remove the oxide hard mask 102 is also performed.
(m) Spacers 130 are formed. The spacers may be formed by depositing a layer of nitride or oxide over the device, and using a mask to etching the nitride or oxide material where spacers are not to be located, as shown in Figure 3. The spacers 130 may be formed of nitride or oxide, or a combination of both.
   It can be preferable to use nitride, as the subsequent contact etch steps (shown in Figures 4(a) and 5(a)) will etch through oxide (TEOS). Using a nitride spacer will ensure that the etch process only happens in the desired region.
   When the spacers are formed of nitride, a thin layer of oxide is first deposited forming an oxide liner (not shown), and the nitride spacers are formed over the oxide liner using ALD or CVD and etching. The thin oxide layer separates the silicon and nitride to ensure no charge or contaminants are transferred from the nitride to the silicon.
   The p-body region (not shown) may be formed at this stage using a Boron (PB) implant. The p+ contact region (not shown) may also be formed using a BF2 or Boron co-implant. The co-implant ensures a good ohmic contact between the metallization and the silicon. The spacers act as a mask to define the location of the p+ contact region, thereby improving ruggedness of the device. These implantations are typically low energy (30keV to 180keV);
(n) An interlayer dielectric (ILD) 132, in this example silicon dioxide (e.g. Tetraethyl orthosilicate (TEOS), is deposited over the surface of the device.

The steps shown in Figures 2(a) to 2(g) generally represent a standard way to form split-gate trenches. It will be understood that alternative steps may be used to form the split-gate trenches, and may replace the steps shown in Figures 2(a) to 2(g).

In the examples herein described, the device is a silicon based split-gate trench MOSFET. However, the skilled person would understand that the device may comprise alternative semiconductor materials; for example, the device may be silicon carbide (SiC) or Gallium Nitride (GaN based. The device may be also an insulated gate bipolar transistor (IGBT).

Figure 3 shows in greater detail the steps of Figure 2(m) that are used to form the spacers 130. Figures 3 (a) to (b) show the step of depositing a layer of nitride or oxide 320 over the device, and Figure 3(c) shows using dry-ion etching to etch the nitride or oxide material where spacers 330 are not to be located. The ion etching process uses a vertical bombardment of ions for a fixed time period that only etches material perpendicular (90°) to the ion beam. This means that the nitride or oxide layer (320) is not etched parallel to the ion beam and spacers are formed.

Figure 4 shows further steps in the method of manufacturing a MOSFET as shown in Figures 2 and 3, to form the source contact The steps shown in Figure 4 follow the steps of Figure 2, such that step (a) in Figure 4 is performed after step (n) of Figure 2. Many of the features shown in Figure 4 are similar to those shown in Figure 2 and therefore carry the same reference numerals.

The steps of the method shown in Figure 4 are performed in order from (a) to (b) as follows:
(a) The ILD 132 is etched in the mesa region 114. A masking layer such as a photoresist is used to etch the ILD 132 in the mesa region. In this example, the spacer is a nitride spacer and the etchant is selected to have an etch selectively that either only removes oxide, or removes oxide substantially more than nitride. This etching process is therefore self-aligned with the spacer 130, as the selective etchant will terminate the etch process either on the surface of or within the nitride spacer. The silicon in the mesa region 114 will not be removed. As the mesa region 114 protrudes above the surface of the trenches 110, as described in relation to Figure 2(h), this allows a greater tolerance in the etching and photolithographic process; for example, the etched area;
(b) The source contact is manufactured by forming a Titanium Nitride (TiN) silicide layer (not shown) in the etched region, to ensure that the Ohmic contact between n+ region 128 and the p+ region (not shown) is as low as possible. A tungsten (W) region is deposited in the etched region, to form a plug contact 134. The plug contact fills the width of the etched region between the two adjacent ILD regions 132. An Aluminium Copper (AICu) alloy is deposited to form the source metallisation 136.

Figure 5 shows alternative further steps in the method of manufacturing a MOSFET as shown in Figure 2. The steps shown in Figure 5 follow the steps of Figure 2, such that the steps in Figure 5 are performed after step (n) of Figure 2. Many of the features shown in Figure 5 are similar to those shown in Figure 2 and therefore carry the same reference numerals. The steps shown in Figure 5 are used to form the gate contact. The steps of Figure 5 may be performed simultaneously on different areas of the same device as the steps of Figure 4.

The steps of the method shown in Figure 5 are performed in order from (a) to (b) as follows:
(a) The ILD 132 is etched over the trenches 110. A masking layer such as a photoresist is used to etch the ILD 132. In this example, the spacer is a nitride spacer and the etchant is selected to have an etch selectively that either only removes oxide, or removes oxide substantially more than nitride. This etching process is therefore self-aligned with the spacer 130, as the selective etchant will terminate the etch process either on the surface of or within the nitride spacer. The horizontal width of the etched region is therefore limited by the spacers 130, and the etch process will terminate on the gate polysilicon 124 and will not etch the mesa region. This therefore allows for a greater tolerance in the etching and photolithographic process; for example, the etched area;
(b) The gate pickup contact is manufactured by forming a Titanium Nitride (TiN) silicide layer (not shown) in the etched region. A tungsten (W) region is deposited in the etched region, to form a plug contact 134. The plug contact fills the width of the etched region between adjacent ILD regions 132. An Aluminium Copper alloy is deposited to form the gate metallisation 138.

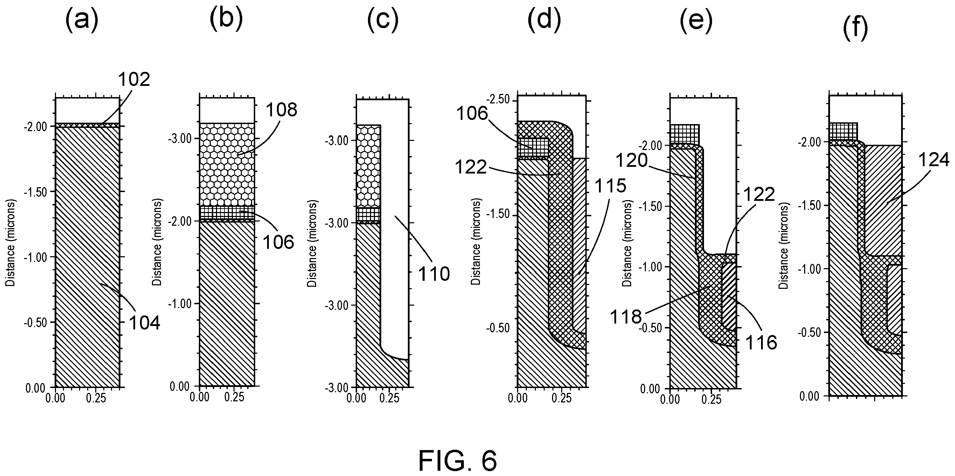

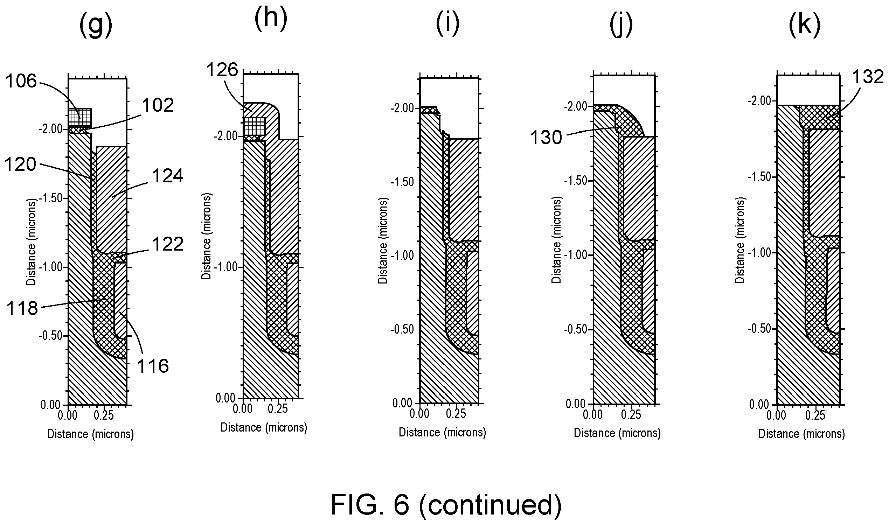

Figure 6 shows a simulation of steps in a method of manufacturing a MOSFET according to an embodiment of the disclosure. It will be appreciated that the steps of the method shown in Figures 6(a) to 6(k) generally correspond to the steps shown in Figures 2(a) to 2(n), in that:
- Figures 6(a) to 6(c) represent the same steps as Figures 2(a) to 2(c);
- Figure 6(d) represents a subset of the steps shown in Figure 2(d) and 2(e), up to the step of etching the polysilicon in Figure 2(e);
- Figures 6(e) and 6(f) represent the same steps as those shown in Figure 2(f);
- Figure 6(g) represents the same steps as shown in Figure 2(l);
- Figure 6(h) represents the same steps as shown in Figures 2(g) to 2(i);
- Figure 6(i) represents the same steps as shown in Figure 2(l);
- Figure 6(j) represents the same steps as shown in Figure 2(m); and
- Figure 6(k) represents the same steps as shown in Figure 2(n).

Figure 6 shows steps of a method of manufacture that are performed in order from (a) to (k) as follows:
(a) A pad oxide layer 102 having a thickness of 550Å is formed over a silicon substrate 104;
(b) A trench hardmask (HM) is deposited over the pad oxide layer 102, this usually includes a nitride layer 106 and a photoresist layer;
(c) The photoresist layer 108 is patterned and using photolithography. The silicon substrate 104, the pad oxide layer 102, the nitride layer 106, and the photoresist layer 108 are etched to form trenches 110 within the device;
(d) The photoresist layer is stripped. A trench oxide liner 112 is deposited on the inner walls and lower surface of the trench and over the upper surface of the mesa region 114 between adjacent trenches. This may be performed by oxidation of the trench sidewalls. Prior to the deposition of the thick liner oxide 112, a thin high quality oxide may be thermally grown. Polysilicon 115 is formed within the trenches 110 and over an upper surface of the device. The polysilicon is planarised using chemical mechanical planarization (CMP);
(e) The polysilicon is etched within the trenches 110, such that the polysilicon is recessed below the upper surface of the trenches 110 and forms a buried field plate 116. A further etching process is performed to etch back the liner oxide layer 112 in the mesa region 114 and along the sidewalls of the trenches 110 above the buried field plate 116, such that both a thick oxide liner 118 remains along the sidewalls adjacent to the buried field plate 116, but only a thin oxide liner 120 remains along the mesa region 114 and the sidewalls of the trenches 110 at a shallower depth than the buried field plate 116, where the thin oxide liner 120 has a thickness substantially less than the thick oxide liner 118. Further oxide 122 is then formed within the trenches 110 (this may be done using high-density-plasma chemical vapour deposition or by oxidation), over the buried field plate 116 within the trenches 110;
(f) A conductive polysilicon region is then deposited over the device and within each trench 110. The conductive polysilicon region is then planarised using chemical mechanical planarization (CMP) or using a dry-etch step. This forms the gate polysilicon region 124;
(g) An isotropic etch process is performed a depth of 450Å to remove the thin oxide layer 120 along both sidewalls of each trench, above the upper surface of the gate polysilicon region 126;
(h) An n-type doped polysilicon 126 having thickness 1000Å is deposited over the upper surface of device including over the trenches 110 and the mesa region 114 such that a layer 128 of the n-type doped polysilicon is formed over the exposed upper surfaces of the trenches 110, mesa region 114 and the exposed regions of the sidewalls of the trenches. A rapid thermal processing (RTP) step in performed in which the device is twice annealed at a temperature of 1050°C for a few second only to thermally drive the dopants from the n-type doped polysilicon layer 126 into the mesa region 114.;
(i) An etch process is used to remove the nitride hard mask 106. An etch process is performed to remove the polysilicon to a depth of 1700Å. A further etch process is performed to remove the area of the silicon exposed in the step shown in Figure 6(g), to a depth of 200Å;
(j) In this example, an oxide spacer having a thickness of 2000Å is formed. This may be done using the method as shown in Figure 3. After the spacer is formed, the p-body region may be formed at this stage using a Boron (PB) implant. A rapid thermal process is then performed in which the device is annealed at a temperature of 1050°C. After the p-body region is implanted, the p+ contact is implanted below the p-body. This is typically a BF2 (boron fluorine) or boron co-implant. This implant helps to ensure an Ohmic contact to the source metallisation and the silicon. After implantation, a rapid thermal process is performed to anneal or activate the implantation. These implantations are typically low energy (30keV to 180keV). The oxide spacer acts as a mask for the p+ contact implantation;
(k) An interlayer dielectric (ILD) 132 or plug, in this example silicon dioxide (e.g. Tetraethyl orthosilicate (TEOS)), having a thickness 3000Å is deposited over the surface of the device. The TEOS is then planarised using chemical mechanical planarization (CMP). To form the source contact, a TiNi silicide layer (not shown) is formed to ensure there is a low resistance ohmic contact between silicon and metallisation. A gate metallisation is then formed over the device.

The steps of the method shown in Figure 6 are simulated as being performed to form a device having 0.8µm cell pitch. It will be understood that the measurements and dimensions given in the example of Figure 6 are an example only and the device is not limited to these dimensions.

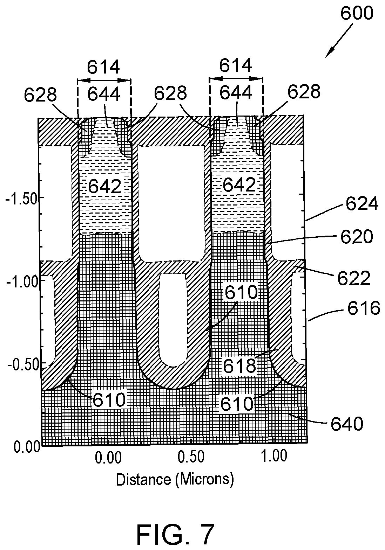

This results in a final device having a cross section as in Figure 7, which shows a simulated cross-section of a split-gate MOSFET according to an embodiment of the disclosure. Many of the features are similar to those shown in Figures 2 to 6 and therefore have similar reference numerals. The semiconductor device 600 includes a positively doped n-type voltage sustaining region (or n-drift region) 640 formed within a semiconductor substrate. In this example, the n-drift region 640 is an epitaxial layer. Whilst not shown, the device may include a drain or collector region located underneath the drift region 640. In the example shown, the device includes two gate trenches 610 each extending downwardly into the n-drift region 640 from an upper surface of an n+ contact region 628. During operation, a conduction channel is formed between the n+ contact region 628 and the drift region 640 by application of a positive voltage to the gate.

Three gate trenches 610 are formed, which are laterally spaced from each other. Whilst three gate trenches 610 are shown for example only, it will be appreciated that the device may include more or less gate trenches. Each gate trench 610 includes an insulation layer 618, 620 formed along the inner sidewalls and the lower surface of the gate trench 610. In this example the insulation layer 618, 620 is an oxide layer (e.g. silicon dioxide), though other insulating materials may be used. In examples where the insulation layer 618, 620 is a silicon dioxide liner, the silicon dioxide liner 618, 620 may be thermally grown and/or deposited.

The gate trenches 610 have a split-gate structure including a gate conductive, polysilicon region 624 formed in an upper portion of each trench 610, and a buried field plate 616 (or source polysilicon region) formed in a lower portion of each trench 610. The gate polysilicon region 624 and the buried field plate 616 of each trench are separated by an oxide layer 622.

Along the upper portion, the insulation layer 620 is thinner and the gate conductive region 624 defines a vertical channel. In a lower portion of the gate trenches, the insulation layer 618 is thicker than in the upper portion, therefore the conductive source polysilicon region 616 acts as a field plate at source potential and is insulated by the thicker insulation layer from the drain region of the device. The gate conductive region 624 and the buried field plate 616 may be formed of a conducting material, such as metal or doped polysilicon.

Above the n-drift region 640, and adjacent to and between the gate trenches 610 within the mesa region 614, there is provided a p-body region 642. The p-body region 642 is a p-type doped semiconductor and may generally extend to a depth in the device, which corresponds with or is similar to the depth of the gate conductive region 624. In the example shown, the depth of the p-body region 642 is less than the depth of the gate conductive region 624 in order to ensure that the gate conductive region 624 is able to provide switching along the full length of the p-body region 642. The n+ contact region 628 is provided above the p-body region 642.

Adjacent gate trenches 610 are separated by a mesa region 614. A p+ contact region 644 is formed within the mesa region within the p-body region 642 and between adjacent n+ contact regions 628.

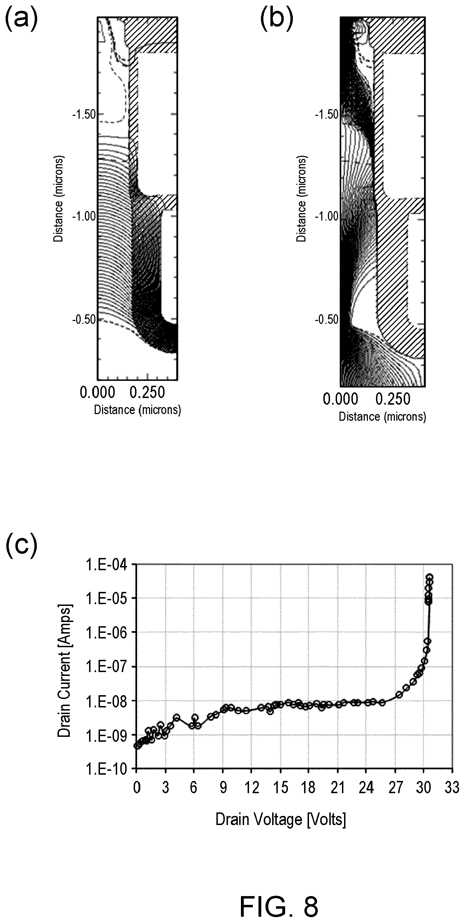

Figure 8 shows a simulation of BVdss of a MOSFET according to an embodiment of the disclosure. This simulation is run in a device having a 25V V_{ds} (drain-source) rating. Figure 8(a) shows the drain potential contours and depletion boundaries 750 when the device is in avalanche. Figure 8(b) shows the drain current flowlines through the device when the device is in avalanche. These figures show (a): How the drain voltage is supported across the cell in terms of potentials (voltage) and depletion boundary when the device is in avalanche (drain source voltage > breakdown voltage), and (b): The avalanche current (black lines) flowlines between drain and source. Figure 8(c) shows a simulation plot of drain voltage against drain current, showing at what value of drain voltage the device will go into avalanche as a function of the drain current. This shows that the improved device has increased avalanche voltage, and thus shows that the herein disclosed device has improved performance.

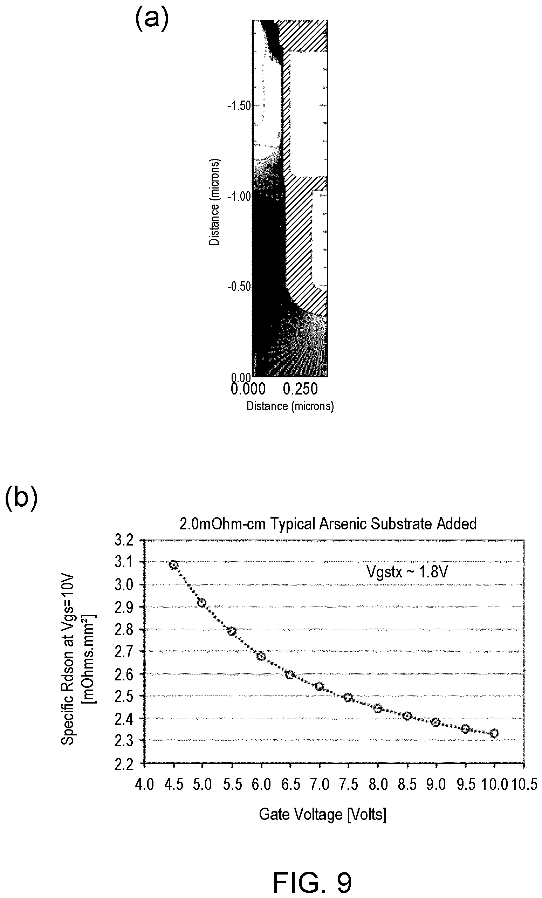

Figure 9 shows a simulation of specific on-state resistance of a MOSFET according to an embodiment of the disclosure. Figure 9(a) shows the on-state current flowlines between the source and the drain when the device is fully conducting. Figure 9(b) shows a simulation plot showing the specific on-state resistance when the device is conducting current as a function of gate voltage. This shows that the on-state resistance is reduced, and the channel resistance is reduced.

### Reference Numerals

- 102: Pad oxide layer
- 104: Silicon substrate
- 106: Nitride layer
- 108: Photoresist
- 110: Gate trench
- 112: Liner oxide layer
- 114: Mesa region
- 115: Polysilicon
- 116: Buried field plate
- 118: Thick oxide liner
- 120: Thin oxide liner
- 122: Oxide layer
- 124: Gate polysilicon region
- 126: n-type doped polysilicon
- 128: n-type doped region
- 130: Spacer
- 132: Interlayer dielectric

- 134: Plug contact
- 136: Source metallisation
- 138: Gate pickup metallisation
- 320: Oxide or nitride layer
- 330: Spacer
- 600: Semiconductor device
- 610: Trench
- 616: Buried field plate
- 618: Thick oxide line
- 620: Thin oxide layer
- 622: Oxide layer
- 624: Gate polysilicon
- 628: n+ contact region
- 640: n-drift region
- 642: p-body region
- 644: p+ contact region

## Claims

1. A method of manufacturing a semiconductor power device, the method comprising:
forming at least two trench regions within a semiconductor region, wherein two laterally adjacent trench regions are separate by a mesa region of the semiconductor region;
etching each trench region such that the mesa region extends above an upper surface of each trench region;
forming a plurality of spacers, wherein the spacers are located over each trench region and are adjacent to the mesa region;
forming an insulating region over an upper surface of the device; and
etching the insulating region.

2. A method according to claim 1, wherein the insulating region and the spacers have a high etch selectivity.

3. A method according to claim 2, wherein etching the insulating region comprises etching the insulating material over the trench regions to form an etched gate recess, and wherein a width of the etched gate recess is limited by the spacers.

4. A method according to claim 3, wherein the method further comprises forming a gate contact by depositing a conductive material in the etched gate recess.

5. A method according to any of claims 2 to 4, wherein etching the insulating region comprises etching the insulating material above the mesa region to form an etched source recess, wherein a depth of the etched source recess is limited by the spacers.

6. A method according to claim 5, further comprising forming a source contact region by depositing a material with a dopant of a first conductivity type over an upper surface of the device, and thermally diffusing the dopant of the first conductivity type into the mesa region.

7. A method according to any preceding claim, wherein forming each trench region comprises forming a conductive region in an etched trench recess, and wherein etching each trench region comprises etching the conductive region such that the mesa region extends above an upper surface of the conductive region.

8. A method according to any preceding claim, wherein after etching each trench region, the method further comprises forming a conductive region in each trench region, wherein the conductive region is formed such that the mesa region extends above an upper surface of the conductive region.

9. A method according to any preceding claim, wherein prior to forming the spacers, the method further comprises forming a plurality of contact regions of a first conductivity type within the mesa region, wherein forming a plurality of contact regions comprises:
depositing a dopant of a first conductivity type over an upper surface of the device; and
thermally diffusing the dopant of a first conductivity type into the mesa region.

10. A method according to any preceding claim, wherein after forming the spacers, the method further comprises forming a plurality of contact regions of a second conductivity type within the mesa region, wherein the spacers act as a mask during implantation of the contact regions of a second conductivity type.

11. A semiconductor power device, comprising:
a semiconductor region;
at least two trench regions within the semiconductor region, wherein each trench region comprises a conductive region, and wherein two laterally adjacent trench regions are separated by a mesa region of the semiconductor region, and wherein the mesa region extends above an upper surface of each trench region;
two or more contact regions of a first conductivity type located in the mesa region and wherein the contact regions are in contact with the two adjacent trench regions so that, in use, a channel is formed along a side of each trench region; and
a plurality of spacers located over each trench region and adjacent to the mesa region.

12. A semiconductor power device according to claim 11, wherein each trench region comprises a conductive region, and wherein the device further comprises a gate contact coupled with a conductive region of at least one trench region and wherein the gate contact is located laterally between two spacers.

13. A semiconductor power device according to any of claims 11 to 12, wherein the device comprises a source contact located completely over the mesa region.

14. A semiconductor device according to any of claims 11 to 13, wherein the trench regions comprise split-gate trench regions comprising:
an upper conductive region formed in an upper portion of each split-gate trench region;
a lower conductive region formed in a lower portion of each split-gate trench region; and
an insulation layer formed along sidewalls, a lower surface of each split-gate trench regions and between the upper conductive region and the lower conductive region, wherein the mesa region extends above an upper surface of the upper conductive region of each trench region.

15. A semiconductor power device having an active region and a gate pickup region, wherein the active region comprises a semiconductor device having a source contact according to claim 23 and wherein the gate pickup region comprises a semiconductor device having a gate contact according to claim 20.
